# FASCICULE DE BREVET EUROPEEN

(11) **EP 1 958 319 B1**
(45) Date de publication et mention de la délivrance du brevet: **31.08.2016**
(21) Numéro de dépôt: 06842118.9
(22) Date de dépôt: 07.12.2006
(51) Int. Cl.: H02K 9/20

(54) **DISPOSITIF DE REFROIDISSEMENT A CALODUC D'UN REGULATEUR DE TENSION D'UNE MACHINE ELECTRIQUE TOURNANTE, TEL QU'UN ALTERNATEUR OU UN ALTERNO-DEMARREUR**
WÄRMERÖHRENVORRICHTUNG ZUR KÜHLUNG EINES SPANNUNGSREGULATORS EINER ROTIERENDEN ELEKTRISCHEN MASCHINE SOWIE WECHSELRICHTER ODER STARTVORRICHTUNG FÜR EINEN WECHSELRICHTER
HEAT PIPE DEVICE FOR COOLING A VOLTAGE REGULATOR OF A ROTATING ELECTRIC MACHINE, SUCH AS AN ALTERNATOR OR AN ALTERNATOR-STARTER

(30) Priorité: 08.12.2005 FR 0512468
(43) Date de publication de la demande: 20.08.2008
(73) Titulaire: VALEO EQUIPEMENTS ELECTRIQUES MOTEUR, 94046 Créteil (FR)
(72) Inventeur: FAKES, Michel, 59113 Seclin (FR); VASILESCU, Claudiu, 75020 Paris (FR); RICHARD, Daniel, 91800 Boussy Saint Antoine (FR)
(74) Mandataire: Gamonal, Didier
(86) Numéro de dépôt international: PCT/FR2006/051307
(87) Numéro de publication internationale: WO 2007/066048

(56) Documents cités:
- EP-A- 0 731 550
- FR-A- 2 745 445
- US-B1- 6 169 344
- PATENT ABSTRACTS OF JAPAN vol. 1995, no. 10, 30 novembre 1995 (1995-11-30) -& JP 07 170695 A (MITSUBISHI ELECTRIC CORP), 4 juillet 1995 (1995-07-04)
- PATENT ABSTRACTS OF JAPAN vol. 013, no. 081 (E-719), 23 février 1989 (1989-02-23) -& JP 63 262044 A (MITSUBISHI ELECTRIC CORP), 28 octobre 1988 (1988-10-28)
- PATENT ABSTRACTS OF JAPAN vol. 005, no. 189 (M-099), 28 novembre 1981 (1981-11-28) -& JP 56 108098 A (MATSUSHITA ELECTRIC IND CO LTD), 27 août 1981 (1981-08-27)
- PATENT ABSTRACTS OF JAPAN vol. 016, no. 423 (E-1260), 7 septembre 1992 (1992-09-07) -& JP 04 145860 A (TOSHIBA CORP), 19 mai 1992 (1992-05-19)

## Description

### Domaine de l'invention

L'invention concerne un dispositif de refroidissement comportant un caloduc dont la partie d'évaporation se trouve dans une zone chaude et la partie de condensation dans une froide, ledit caloduc étant destiné à évacuer la chaleur de la zone chaude vers la zone froide.

### Etat de la technique

Dans ces dispositifs de refroidissement, connus notamment par le document US 4 295 067 conforme au préambule de la revendication 1, la partie d'évaporation permet d'absorber de la chaleur et la partie de condensation d'évacuer la chaleur.

### Objet de l'invention

La présente invention a pour but de tirer partie du caloduc.

Ce but est atteint selon l'invention par la partie caractérisante de la revendication 1.

Grâce à l'invention on refroidit bien le régulateur de tension en sorte que les performances de la machine électrique tournante sont augmentées, ainsi que sa durée de vie.

L'invention permet d'augmenter la puissance de la machine et ce de manière simple et économique.

Suivant une caractéristique le caloduc comporte entre ces parties d'évaporation et de condensation une partie électriquement isolante de façon que les zones chaude et froide soient isolées électriquement l'une de l'autre. Ainsi la partie de condensation du caloduc peut être reliée au dissipateur positif d'un dispositif de redressement.

Suivant une caractéristique la partie de condensation du caloduc est implantée à proximité d'une borne de liaison reliée par un câble à la borne positive d'une batterie en sorte que l'on évacue bien les calories.

### Description sommaire des dessins

L'invention sera mieux comprise, et d'autres buts, caractéristiques, détails et avantages de celle-ci apparaîtront plus clairement au cours de la description explicative qui va suivre faite en référence aux dessins schématiques annexés donnés uniquement à titre d'exemple illustrante des modes de réalisation de l'invention et dans lesquels :
- la figure 1 est une vue de dessus d'une partie d'un palier arrière d'une machine électrique tournante et illustre de façon schématique une liaison d'un régulateur de tension avec la partie d'évaporation d'un caloduc selon un mode d'application de l'invention, et
- la figure 2 est une vue partielle en coupe selon la ligne II-II de la figure 1 ;
- la figure 3 est une vue en coupe du caloduc de la figure 1 monté sur le régulateur de tension de la figure 1 ;
- les figures 4 à 6 sont des vues analogues à la figure 2 pour respectivement un deuxième, un troisième et un quatrième mode de liaison du régulateur de tension avec la partie d'évaporation d'un caloduc selon l'invention ;
- la figure 7 est une vue schématique d'un dispositif de refroidissement selon l'invention, montrant l'utilisation d'un caloduc plat et large ;
- la figure 8 est une vue schématique d'encore un autre mode de réalisation du dispositif de refroidissement selon l'invention, dans lequel le caloduc porteur de la puce est relié au carter de la machine électrique,

### Description de l'invention

L'invention sera décrite ci-après dans son application à un palier arrière d'une machine électrique tournante. Cette application n'est cependant donnée qu'à titre d'exemple.

Cette machine électrique tournante est par exemple un alternateur polyphasé notamment pour véhicule automobile. Cet alternateur comporte un carter de forme creuse comportant au moins un flasque avant et un flasque arrière dits palier avant et palier arrière. Ce carter est destiné à être monté sur une partie fixe.

A l'intérieur sont logés un stator entourant un rotor solidaire d'un arbre monté à rotation dans le carter à l'aide de roulements, tels que des roulements à billes, portés centralement respectivement par le palier arrière et le palier avant.

Le stator comporte un corps de stator rainuré portant un bobinage de stator comprenant des enroulements dont le nombre varie en fonction notamment du nombre de phases que comporte l'alternateur. Le corps du stator est porté par le carter en étant implanté à la périphérie externe de celui-ci. Ce corps consiste par exemple en un paquet de tôles.

Un entrefer existe entre la périphérie interne du corps du stator et la périphérie externe du rotor.

Le rotor est par exemple un rotor à griffes ou un rotor à pôles saillants.

L'arbre traverse centralement le rotor en étant lié en rotation à celui-ci par exemple par emmanchement à force, l'arbre comportant à cet effet aux moins une portion à reliefs emmanchée à force dans l'ouverture centrale que comporte le rotor pour ce faire.

L'extrémité avant de l'arbre traverse le palier avant et porte un organe d'entraînement, tel qu'une poulie ou une roue dentée, appartenant à un dispositif de transmission de mouvement, par exemple à courroie(s) ou chaîne(s), intervenant entre l'arbre de l'alternateur et le vilebrequin du moteur thermique du véhicule automobile.

Le rotor comporte un corps de rotor, de préférence en matériau ferromagnétique. Au moins un bobinage d'excitation est associé au corps. Lorsque le bobinage d'excitation est alimenté électriquement, le corps du rotor est aimanté avec formation de pôles magnétiques, le corps du rotor étant configuré en conséquence.

Il se produit alors, lorsque l'arbre tourne, un courant induit dans le bobinage du stator.

Ce courant induit est du type alternatif en sorte qu'il est prévu un dispositif de redressement, tel qu'un pont de diodes ou un pont de transistors du type Mosfet, pour transformer le courant alternatif en un courant continue afin d'alimenter électriquement au moins une charge, telle qu'une charge appartenant au réseau de bord du véhicule et/ou une batterie.

Le dispositif de redressement est doté de plusieurs branches et est le plus souvent porté par le palier arrière de la machine électrique tournante. Ce dispositif comporte un dissipateur positif portant des éléments de redressement positifs, par exemple des diodes positives, un dissipateur négatif portant des éléments de redressement négatifs, tel que des diodes négatives, et un connecteur en matériau électriquement isolant portant des liaisons électriques pour relier électriquement entre eux les éléments de redressement afin de former des branches du dispositif de redressement, tel qu'un pont de diodes, et de relier électriquement les sorties des enroulements, connectées par exemple en étoile ou en triangle, du bobinage du stator au dispositif de redressement.

Le dissipateur négatif est relié électriquement à la masse, tandis que le dissipateur positif porte une borne de sortie, dite borne B+ destinée à être reliée à la borne positive d'une batterie.

Ces dissipateurs sont dans un mode de réalisation métalliques. Avantageusement le dissipateur négatif est constitué par le fond palier arrière de forme creuse.

Le bobinage d'excitation du rotor est relié électriquement à un régulateur de tension pour limiter la tension produite par l'alternateur et protéger les charges.

Dans un mode de réalisation l'alternateur est sans balais et le bobinage d'excitation est fixe. Dans un autre mode de réalisation l'alternateur présente des balais et le bobinage d'excitation est porté par le corps du rotor.

Dans ce cas l'extrémité arrière de l'arbre porte deux bagues collectrices reliées par des liaisons filaires aux extrémités du bobinage d'excitation.

Des balais sont destinés à frotter sur les bagues collectrices. Ces balais sont montés dans un porte-balais appartenant le plus souvent à un ensemble régulateur porte-balais porté également par le palier arrière.

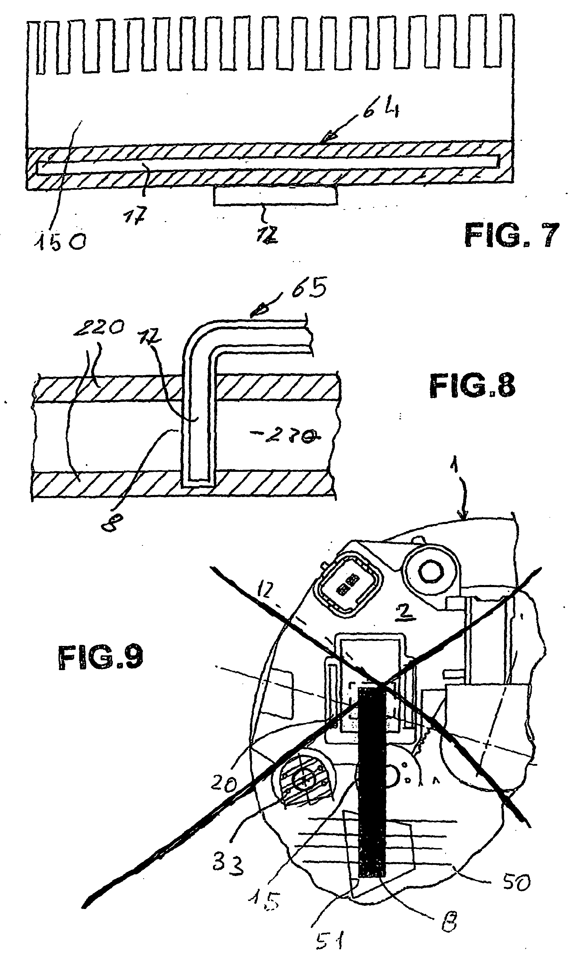

A titre d'exemple on se reportera au document WO 02/29958 divulguant, dans le cadre d'un alternateur à balais et à dispositif de redressement sous la forme d'un pont de diodes,une telle disposition mieux visible dans les figures 7 et 14 à 17 de ce document.

Dans ce document le rotor est un rotor à griffes doté d'un corps comportant deux roues polaires entre lesquelles est intercalé un noyau portant le bobinage d'excitation. Cet alternateur est refroidi par air. Pour ce faire le rotor porte à chacune des ses extrémités axiales un ventilateur et les paliers avant et arrière du carter sont dotés d'ouvertures d'entrée et de sortie d'air pour circulation interne de l'air à l'aide des ventilateurs.

Cette circulation de l'air permet de refroidir les enroulements du stator ainsi que le pont de redressement et l'ensemble régulateur de tension-porte balais coiffés par un capot de protection troué et relié à fixation au palier arrière.

Le régulateur de tension comporte un sous-ensemble comportant par exemple un substrat sur lequel est monté au moins un composant électronique élémentaire de régulation de tension tel qu'une puce.

Ce régulateur assume la régulation de la tension de l'alimentation de la batterie et des charges. Il peut être du type monofonction ou du type multifonction pour notamment dialoguer avec au moins un calculateur et/ou assurer la détection de défauts, tels que la détection d'absence de rotation ou la détection de la rupture de la courroie.

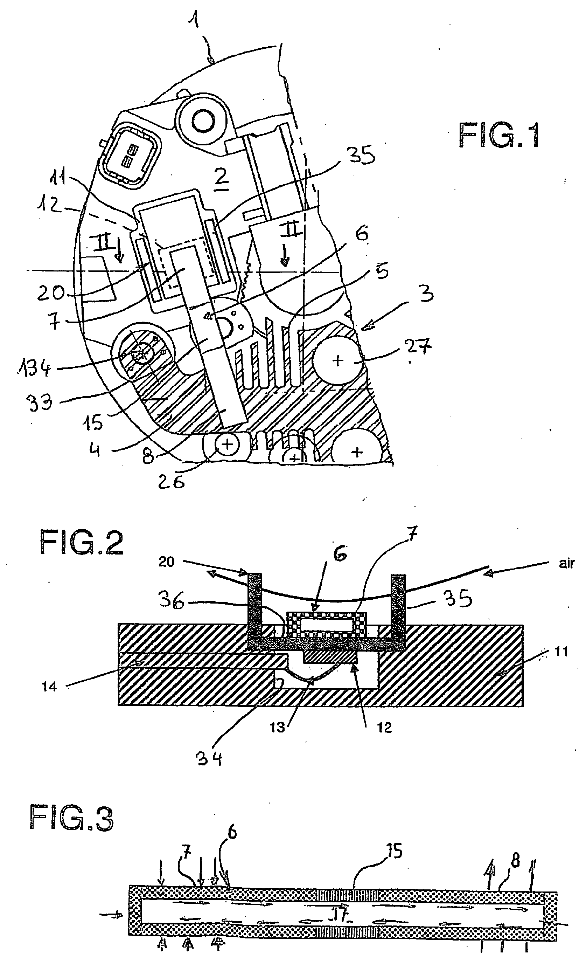

La figure 1 montre une partie du palier arrière désignée par 1 d'une machine électrique tournante, de structure classique, par exemple du type de celui décrit dans le document WO 02/29958 précité.

Ce palier arrière 1 est donc de forme creuse et comporte un fond, visible à la figure 1, doté centralement d'ouvertures de passage d'air et prolongé à sa périphérie externe par un rebord périphérique adjacent au stator. Ce rebord est également doté d'ouvertures de passage d'air.

A la figure 1 on n'a pas représenté le capot de protection coiffant le dispositif de redressement, ici un pont de diodes, pour mieux voir les pièces coiffées par ce capot.

Ainsi sur cette figure, sont indiqués en 2 l'ensemble comprenant le régulateur de tension et le porte-balais, en 33 une patte appartenant au dissipateur positif 4 appartenant au dispositif de redressement 3, comportant ici des éléments de redressement en forme de diodes. Le dissipateur négatif est constitué ici par le fond du palier arrière portant des diodes 26, dites diodes négatives, dont certaines sont visibles à la figure 1. Le dissipateur positif 4, avantageusement métallique, porte également des diodes 27, dites diodes positives. Un connecteur, non visible, intervient entre les deux dissipateurs. Le dissipateur positif 4 est doté ici d'ailettes de refroidissement 5.

Le but de l'invention consiste à assurer le refroidissement du régulateur de tension 2.

Conformément à une caractéristique selon l'invention, le refroidissement est réalisé à l'aide d'un caloduc 6 dont la partie d'évaporation 7 est reliée au régulateur de tension constituant une source chaude. La partie de condensation 8 est, de manière décrite ci-après, reliée à une source froide de la machine électrique tournante. Les parties 7 et 8 sont électriquement conductrices.

Le caloduc 6 est relié directement ou indirectement au composant électronique de régulation du régulateur de tension pour refroidir celui-ci.

Dans cette figure 1, selon un mode de réalisation ne faisant pas partie de l'invention la source froide est le dissipateur positif 4 du dispositif de redressement 3 porté à isolation électrique ici par le palier arrière 1. La partie de condensation 8 du caloduc est montée sur le dissipateur positif 4, plus précisément au voisinage des ailettes de refroidissement 5 du dissipateur 4.

Cette partie de condensation est implantée également au voisinage de la patte 33 du dissipateur 4. Cette patte 33 sert au montage de la borne B+ rapportée par exemple par vissage sur la patte 33 troué à cet effet. A la figure 1 on voit en 134 ce trou. Cette borne est reliée par un câble à la borne positive de la batterie constituant une source froide. Le câble permet donc d'évacuer les calories en sorte que la patte 33 est une source froide.

La partie de condensation 8 est donc ici implantée au voisinage de la patte 37, en étant en contact et solidaire du dissipateur 4, qui est au potentiel positif.

La partie de condensation 8 du caloduc 6 est donc montée à proximité d'une zone froide du dissipateur positif 4 bien refroidi grâce aux ailettes 5.

La partie d'évaporation 7 du caloduc 6 est, selon un mode de réalisation de l'invention, montée sur le régulateur de tension , par exemple de la manière illustrée sur la figure 2, qui montre en 11 une couche en matière plastique appartenant au régulateur de tension et disposée sur le palier arrière 1, et en 12 au moins un composant électronique de régulation, telle qu'une puce, du régulateur de tension dont le boîtier est relié par un fil de connexion électrique 13 à au moins une trace métallique 14 de connexion électrique reliée à un potentiel de référence. Cette trace 14 s'étend dans la couche 11.

Dans le cas représenté, la partie d'évaporation 7 du caloduc 6 est en contact indirect avec la puce 12 et est montée sur une plaque dissipatrice de chaleur 20 de chaleur, mais toute autre possibilité de montage connue, tel qu'un montage sur un dissipateur de chaleur à ailettes de refroidissement, est envisageable. La plaque 20 est solidaire de la couche 11.

Plus précisément la plaque dissipatrice de chaleur 20 est ici métallique et présente en section une forme en U avec deux ailes 35 et un fond 36. Le caloduc 6 s'étend par sa partie 7 au contact de la face supérieure du fond 36, tandis que la puce 12 s'étend au contact de la face inférieure du fond 36. La partie d'évaporation 7 et la puce 12 s'étendent donc de part et d'autre du fond 36. Cette partie 7 du caloduc 6 et la puce 12 sont fixés sur le fond 36 de la plaque 20 par exemple à l'aide d'une colle thermoconductrice. En variante la fixation de ces composants sur le fond 36 est réalisée par brasage.

On notera que la couche 11 présente une cavité 34 pour loger la puce 12, la partie 7, en majeure partie le fond 36, le fil de connexion 13 et l'extrémité libre apparente de la trace 14 reliée électriquement au fil 13.

Les extrémités du fond 36 et les parties basses des ailes 35 sont ancrées dans la couche 11 par exemple par la technique du surmoulage. On notera que la trace 14 est soit au potentiel positif soit au potentiel négatif.

Les ailes 35 s'étendent perpendiculairement à la couche 11 et sont refroidies par circulation de l'air schématisée par une flèche à la figure 2 en sorte que la plaque grâce à ses ailes est une plaque dissipatrice de chaleur formant dissipateur de chaleur.

Du côté de la partie de condensation 8, le caloduc est fixé, de toute manière appropriée par exemple par brasage ou collage, au dissipateur positif 4 du pont de diodes groupées par paires, chaque paire comportant de manière connue une diode positive et une diode négative.

Or le composant électronique, tel que la puce 12, du régulateur de tension, reliée à trace 14 par exemple au potentiel négatif, et le dissipateur positif 4 du pont de diodes possèdent des potentiels électriques différents, si bien que l'utilisation d'un caloduc connu provoquerait un court-circuit entre les deux potentiels. Il en est de même dans tous les cas d'application ou les éléments ou dispositifs auxquels les deux parties du caloduc sont reliées possèdent des potentiels électriques différents.

Pour résoudre ce problème, il est proposer d'utiliser un caloduc tel que représenté sur la figure 3, qui comporte entre ses parties d'évaporation 7 et de condensation 8 une partie électriquement isolante 15 tout en préservant les qualités de super-conducteur thermique du caloduc. Ainsi, la partie évaporateur et la partie condensateur du caloduc faites en un matériau thermiquement et électriquement conducteur sont séparées par la partie électriquement isolante 15, ces trois parties mises bout à bout étant prévues de façon à ne pas modifier le transport du fluide caloporteur 17 à l'intérieur du caloduc pour l'évacuation de la chaleur du régulateur vers le dissipateur 4, sans risque d'un court-circuit, grâce à la partie isolante 15.

Pour mémoire on rappellera que le caloduc 6 comporte une enceinte étanche, ici 7, 15, 8, à l'intérieure de laquelle se trouve le fluide caloporteur 17.

Dans un mode de réalisation économique les parties 7, 8 sont en cuivre ou en nickel et le fluide caloporteur 17 est de l'eau.

Dans un autre mode de réalisation le fluide caloporteur est de l'ammoniaque et les parties 7, 8 en nickel, en aluminium ou en acier inoxydable.

Dans encore un autre mode de réalisation les parties 7, 8 sont en nickel, en cuivre ou en acier inoxydable et le fluide caloporteur est du méthanol.

Bien entendu les parties 7, 8 peuvent être en plusieurs matières.

Par exemple les parties 7, 8 peuvent être en acier plaqué intérieurement avec du cuivre, le fluide caloporteur étant de l'eau.

La partie isolante 15 est dans un mode de réalisation en matière plastique.

Dans le mode de réalisation de la figure 3 le caloduc est du type à pompage capillaire.

Le fluide caloporteur 17 est en équilibre avec sa vapeur. Il y a une faible quantité de liquide en contact avec les parties 7, 15, 8 en sorte que les parties 7 et 8 sont bien isolées électriquement malgré la présence de liquide dans la partie 15.

Dans un mode de réalisations ces parties 7, 15, 8 de forme creuse sont dotées de rainures pour pompage capillaire du fluide caloporteur.

Dans cette figure 3 on a représenté par des flèches la circulation du liquide 17 dans l'enceinte 7, 15, 8 et à l'extérieur on a également schématisé par des flèches respectivement l'absorption de chaleur dans la partie 7 et l'évacuation de chaleur dans la partie 8. Il est à noter qu'un caloduc tel que représenté sur la figure 3 prévoyant une partie électriquement isolante entre ses parties d'évaporation et de condensation peut être utilisé, comme moyen de refroidissement, dans tous les cas d'applications où les éléments ou dispositifs auxquels les deux parties du caloduc sont reliées possèdent des potentiels électriques différents. Le caloduc peut avoir toute forme appropriée, par exemple être un caloduc plat ou de toute autre forme, à condition de comprendre entre ces deux parties d'évaporation et de condensation une partie électriquement isolante.
Lorsque le caloduc est plat celui-ci peut présenter sur l'une de ses faces deux parties d'évaporation séparées par une partie électriquement isolante et sur l'autre de ses faces deux parties de condensation séparées par une partie électriquement isolante.
Le caloduc présente donc au moins une partie d'évaporation et une partie de condensation séparées par une partie électriquement isolante.
De même on peut modifier le ou les dissipateurs 20, 4 pour pouvoir fixé le caloduc par vissage, rivetage, encliquetage ou clinchage.

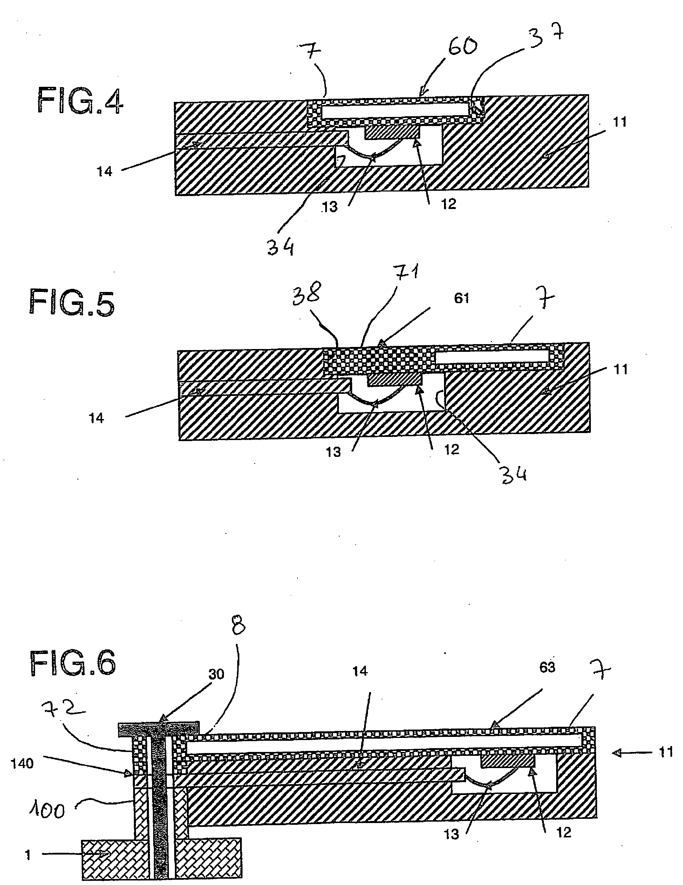

En variante comme visible à la figure 4 la puce 12 est fixée directement, par exemple par collage, sur la partie d'évaporation 7 du caloduc 60. Dans ce cas le caloduc 60 est plus large que le caloduc 6 de la figure 1 et la cavité 34 comporte une partie supérieure élargie 37 pour la réception de la partie 7.

La cavité 34 est donc étagée.

En variante, comme visible à la figure 5, on élargit encore la partie supérieure 38 de la cavité 34 étagée pour loger un caloduc 61 encore plus large en sorte que la zone d'évaporation 7 est déportée par rapport à la puce 12 fixée sur une partie pleine 71 du caloduc adjacente à la partie d'évaporation 7.

Bien entendu la présente invention n'est pas limitée à l'exemple de réalisation décrit.

Le rotor de la machine peut être un rotor à pôles saillants.

En variante, comme décrit dans le document DE 40 187 10 la machine peut comporter deux rotors à griffes et deux stators, le dispositif de redressement, le régulateur de tension et la borne B+ étant portés par le palier avant en forme de couvercle.

La machine peut être refroidit par eau.

Par exemple l'un des palier du carter peut être doté d'ouvertures de passage d'air pour être refroidi par une circulation de l'air créée par un ventilateur solidaire du rotor ou de l'arbre, tandis que l'autre palier comporte au moins une chambre de refroidissement, tel qu'un canal, reliée à un raccord d'entrée et de sortie pour être refroidi par circulation d'un liquide. Ce liquide de refroidissement peut dans un mode de réalisation être le liquide de refroidissement du moteur à combustion interne, appelé également moteur thermique, du véhicule automobile.

Le fond du palier arrière ou du palier avant peut donc être refroidi par circulation d'un liquide.

La machine peut être refroidie uniquement par circulation d'un liquide, le carter de la machine comportant de manière précitée au moins une chambre de refroidissement pour circulation du fluide de refroidissement comme décrit dans le document DE 40 187 10.

Le ventilateur peut être implanté à l'extérieur comme dans les documents DE A 30 12 636 et JP 56199707.

Il en résulte, en considérant ces deux documents que le dispositif de redressement et le régulateur de tension sont en variante portés par le palier avant du carter de la machine ou en variante implantés entre le fond, par exemple du palier arrière et le rotor de la machine.

On peut implanter en variante le dispositif de redressement et le régulateur de tension à la périphérie externe du carter. Dans ce cas la source froide peut être le carter en sorte que la présence de la partie 15 n'est pas obligatoire.

En variante on peut doubler le nombre de composants comme visible à la figure 2 du document DE 40 187 10 précité.

Dans ce cas le caloduc relie entre les deux régulateurs, constituant la source chaude, à une source froide. Le caloduc peut donc avoir une forme en T avec une tête formée par les deux parties d'évaporation reliées entre elles.

La source froide est en variante une portion du carter de la machine refroidie par circulation de liquide en sorte que la présence de la partie 15 n'est pas nécessaire.

Dans les modes de réalisation précédents la chaleur dissipée par la puce est évacuée par convexion forcée via le caloduc.

En variante on peut évacuer la chaleur par conduction dans une partie froide de l'alternateur.

Ainsi comme visible à la figure 6 on peut prolonger la trace 14 pour que l'extrémité 140 de cette trace 14, reliée au potentiel négatif, vienne en contact. avec la face supérieure d'une cheminée 100 appartenant au palier arrière 1, ici à base d'aluminium. La cheminée 100 est dans un mode de réalisation venue de moulage avec le palier arrière 1 métallique.

Le caloduc 63 est également prolongé en sorte que sa zone de condensation 8 s'étende jusqu'au voisinage de la cheminée 100.

Plus précisément le caloduc 63 présente une oreille 72 adjacente à la partie de condensation 8 du caloduc 63 dépourvu ici de partie isolante puisque la trace 14 est au même potentiel électrique que le palier arrière 1. Cette oreille 72 est en contact avec la face supérieure de l'extrémité 140 de la trace elle-même en appui par sa face inférieure sur la cheminée 100. L'extrémité 140 de la trace présente un trou non référencé pour le passage d'un organe de fixation 30. Cet organe de fixation 30 est ici une vis dont la tête prend appui sur l'oreille 72 pour serrage de l'extrémité 140 au contact de la cheminée 100 taraudée pour coopérer avec le filetage de la vis 30. En variante on peut utiliser un goujon vissé dans la cheminée 100 et un écrou venant au contact de l'oreille 72.

La figure 7 fait état d'une autre possibilité de mettre en oeuvre l'invention, qui consiste à utiliser un caloduc 64 plat, dit "spreader heat pipe" pour augmenter la capacité de transfert de chaleur. La puce 12 est fixée sous la cavité très large et de faible hauteur du caloduc 64 et celui-ci se trouve coincé entre la puce et un grand dissipateur 150 à ailettes.

Dans un autre mode de réalisation la partie de condensation du caloduc est implantée dans une chambre de refroidissement de l'alternateur parcourue par un liquide de refroidissement.

Ainsi, comme visible à la figure 8, le refroidissement du régulateur peut être amélioré si la machine est refroidie par un liquide de refroidissement tel que l'eau de refroidissement du moteur thermique du véhicule. Une poche d'eau pourrait alors être prévue à cette fin dans le carter et la partie de condensation 8, alors coudée, du caloduc 65 plongera directement dans l'eau, comme cela est montré schématiquement sur la figure 8, sur laquelle les références 220 et 230 désignent respectivement les parois du canal d'écoulement de l'eau et l'espace interne de celui-ci.

La machine électrique tournante est en variante un alterno-démarreur, c'est à dire un alternateur réversible permettant de transformer également de l'énergie électrique en énergie mécanique notamment pour démarrer le moteur à combustion interne du véhicule automobile. Dans ce cas le dispositif de redressement comporte de manière avantageuse des transistors du type MOSFET et peut être, dans un mode de réalisation, monté, ainsi que le régulateur de tension, dans un boîtier externe de la machine avec intervention de câbles entre le boîtier et la machine comme décrit dans le document FR A 2 745 445 auquel on se reportera.

Ainsi le porte-balais peut être distinct du régulateur de tension. Le caloduc selon l'invention intervient entre le régulateur de tension et le boîtier externe contenant le dispositif de redressement et le régulateur de tension. Ce boîtier comporte un fond fermé par un couvercle métallique formant dissipateur de chaleur. Le caloduc intervient avantageusement entre le régulateur de tension et le dissipateur de chaleur formant source froide, sa partie de condensation étant reliée au dissipateur de chaleur ou en variante à une borne portée par le boîtier et reliée par un câble à la borne positive de la batterie.
Bien entendu toutes les combinaisons sont possibles. Ainsi on peut inverser les structures, par exemple la trace 14 est dans un mode de réalisation reliée au potentiel positif contrairement aux modes de réalisation des figures 2 et 4 à 5 dans lesquels la trace 14 est reliée au potentiel négatif. Dans le cas ou la trace 14 est reliée au potentiel positif, le caloduc peut être dépourvu de partie isolante.
De même comme indiqué de manière précitée le régulateur de tension, le dispositif de redressement et la borne de liaison avec la borne positive de la batterie sont en variante portés par le palier avant du carter de la machine ou par la périphérie externe du carter de la machine ou un boîtier externe à la machine, qui en variante est refroidi par circulation de liquide.

Le régulateur de tension peut être doté de plusieurs traces 14 positives et négatives notamment pour relier également la puce au potentiel positif.

Concernant la fixation du caloduc sur le dissipateur, on peut envisager, de manière précitée, comme moyen de fixation le collage ou brasage. Pour le brasage, il faut prêter attention à la température du brasage, notamment si le caloduc est fixé après la fixation de la puce sur le dissipateur, comme on le voit sur la figure 2. On pourrait également envisager d'adapter la forme du dissipateur pour pouvoir y fixer le caloduc à l'aide d'un vissage, rivetage, clipsage ou encore clinchage. Si la puce est directement en contact avec le caloduc, comme dans les cas des figures 4 à 7, celle-ci sera brasée ou collée. En plaçant la puce à côté de la cavité du caloduc, conformément à la figure 5, le brasage peut se faire à l'aide d'un laser.

La colle utilisée est avantageusement conductrice de chaleur. Elle peut être également dans un mode de réalisation électriquement isolante.

Le caloduc peut constituer un moyen de connexion électrique lorsque ces deux parties sont au même potentiel électrique. Par exemple lorsque la partie 7 est montée sur le régulateur de manière précitée et lorsque la partie 8 est montée sur le palier arrière.

Bien entendu toutes les caractéristiques énoncées ci-dessus sont à considérer isolément ou en combinaison.

## Revendications

1. Dispositif de refroidissement comportant un caloduc dont les parties d'évaporation et de condensation se trouvent respectivement dans une zone chaude et froide, ledit caloduc étant destiné à évacuer la chaleur de la zone chaude vers la zone froide, **caractérisé en ce que** la partie d'évaporation (7) du caloduc (6, 60, 61, 63) est reliée à un régulateur de tension (2) appartenant à une machine électrique tournante, telle qu'un alternateur ou un alterno-démarreur, comportant un carter doté d'un palier avant et d'un palier arrière, l'un de ces paliers portant au moins un dispositif de redressement de courant comportant un dissipateur positif (4) portant des élément de redressement, tel que des diodes ou des transistors du type MOSFET et **en ce que** la partie de condensation (8) du caloduc (63) est reliée à l'un des paliers constituant une source froide.

2. Dispositif selon la revendication 1, **caractérisé en ce que** le carter comporte au moins une chambre pour circulation d'un fluide de refroidissement, tel que le liquide de refroidissement d'un moteur à combustion interne, et **en ce que** la partie de condensation (8) du caloduc est implantée dans la chambre de refroidissement.

3. Dispositif selon la revendication 1, **caractérisé en ce que** le palier arrière (1) de la machine électrique tournante porte le régulateur de tension (2) et **en ce que** la partie de condensation (8) du caloduc (63) est reliée au palier arrière (1).

4. Dispositif selon la revendication 3, **caractérisé en ce que** la partie de condensation (8) du caloduc (63) est reliée à une cheminée (100) solidaire du palier arrière (1).

5. Dispositif selon la revendication **caractérisé en ce que** le régulateur de tension est monté dans un boîtier externe à la machine électrique tournante, **en ce que** le boîtier comporte un dissipateur de chaleur et **en ce que** la partie de condensation du caloduc est reliée au dissipateur de chaleur.

6. Dispositif selon la revendication 1, **caractérisé en ce que** le caloduc (6, 60, 61) comporte entre ses parties de condensation (8) et d'évaporation (7) une partie électriquement isolante (15) de façon que les zones chaude et froide soient isolées électriquement l'une de l'autre.

7. Dispositif selon l'une quelconque des revendications précédentes **caractérisé en ce que** le régulateur de tension comporte au moins un composant électronique de régulation (12) fixé directement ou indirectement sur la partie d'évaporation (7) du caloduc (6, 60, 61, 63).

8. Dispositif selon la revendication 7, **caractérisé en ce que** le régulateur de tension comporte une couche en matière plastique (11) dotée d'une cavité (34) pour le logement du composant électronique (12).

## Patentansprüche

1. Kühlvorrichtung, die ein Wärmeleitrohr aufweist, dessen Verdampfungs- und Kondensationsteile sich in einer warmen bzw. kalten Zone befinden, wobei das Wärmeleitrohr dazu bestimmt ist, die Wärme von der warmen Zone zur kalten Zone abzuleiten, **dadurch gekennzeichnet, dass** der Verdampfungsteil (7) des Wärmeleitrohrs (6, 60, 61, 63) mit einem Spannungsregler (2) verbunden ist, der zu einer drehenden elektrischen Maschine wie einem Drehstromgenerator oder einem Starter-Generator gehört, die ein Gehäuse aufweist, das mit einem vorderen Lager und mit einem hinteren Lager ausgestattet ist, wobei eines dieser Lager mindestens eine Stromgleichrichtervorrichtung trägt, die einen positiven Ableiter (4) aufweist, der Gleichrichterelemente wie Dioden oder Transistoren von der Art MOSFET trägt, und dass der Kondensationsteil (8) des Wärmeleitrohrs (63) mit einem der Lager verbunden ist, das eine kalte Quelle bildet.

2. Vorrichtung nach Anspruch **dadurch gekennzeichnet, dass** das Gehäuse mindestens eine Kammer für die Zirkulation eines Kühlfluids wie der Kühlflüssigkeit eines Verbrennungsmotors aufweist, und dass der Kondensationsteil (8) des Wärmeleitrohrs in die Kühlkammer eingesetzt ist.

3. Vorrichtung nach Anspruch **dadurch gekennzeichnet, dass** das hintere Lager (1) der drehenden elektrischen Maschine den Spannungsregler (2) trägt, und dass der Kondensationsteil (8) des Wärmeleitrohrs (63) mit dem hinteren Lager (1) verbunden ist.

4. Vorrichtung nach Anspruch 3, **dadurch gekennzeichnet, dass** der Kondensationsteil (8) des Wärmeleitrohrs (63) mit einem fest mit dem hinteren Lager (1) verbundenen Schacht (100) verbunden ist.

5. Vorrichtung nach Anspruch **dadurch gekennzeichnet, dass** der Spannungsregler in ein Gehäuse außerhalb der drehenden elektrischen Maschine montiert ist, dass das Gehäuse einen Wärmeableiter aufweist, und dass der Kondensationsteil des Wärmeleitrohrs mit dem Wärmeableiter verbunden ist.

6. Vorrichtung nach Anspruch **dadurch gekennzeichnet, dass** das Wärmeleitrohr (6, 60, 61) zwischen seinen Kondensations- (8) und Verdampfungsteilen (7) einen elektrisch isolierenden Teil (15) aufweist, damit die warme und die kalte Zone elektrisch voneinander isoliert sind.

7. Vorrichtung nach einem der vorhergehenden Ansprüche, **dadurch gekennzeichnet, dass** der Spannungsregler mindestens ein elektronisches Regelbauteil (12) aufweist, das direkt oder indirekt am Verdampfungsteil (7) des Wärmeleitrohrs (6, 60, 61, 63) befestigt ist.

8. Vorrichtung nach Anspruch 7, **dadurch gekennzeichnet, dass** der Spannungsregler eine Schicht aus Kunststoff (11) aufweist, die mit einem Hohlraum (34) zur Unterbringung des elektronischen Bauteils (12) ausgestattet ist.

## Claims

1. Cooling device comprising a heat pipe of which the evaporation and condensation parts are located respectively in a hot zone and a cold zone, said heat pipe being intended to discharge the heat from the hot zone to the cold zone, **characterized in that** the evaporation part (7) of the heat pipe (6, 60, 61, 63) is linked to a voltage regulator (2) belonging to a rotating electric machine, such as an alternator or an alternator-starter, comprising a housing provided with a front bearing and a rear bearing, one of these bearings bearing at least one current rectifying device comprising a positive dissipater (4) bearing rectifying elements, such as diodes or transistors of the MOSFET type and **in that** the condensation part (8) of the heat pipe (63) is linked to one of the bearings forming a cold source.

2. Device according to Claim 1, **characterized in that** the housing comprises at least one chamber for the circulation of a coolant, such as the coolant of an internal combustion engine, and **in that** the condensation part (8) of the heat pipe is located in the cooling chamber.

3. Device according to Claim 1, **characterized in that** the rear bearing (1) of the rotating electric machine bears the voltage regulator (2) and **in that** the condensation part (8) of the heat pipe (63) is linked to the rear bearing (1).

4. Device according to Claim 3, **characterized in that** the condensation part (8) of the heat pipe (63) is linked to a chimney (100) secured to the rear bearing (1).

5. Device according to Claim 1, **characterized in that** the voltage regulator is mounted in a casing external to the rotating electric machine, **in that** the casing comprises a heat sink and **in that** the condensation part of the heat pipe is linked to the heat sink.

6. Device according to Claim 1, **characterized in that** the heat pipe (6, 60, 61) comprises, between its condensation (8) and evaporation (7) parts, an electrically insulating part (15) such that the hot and cold zones are electrically insulated from one another.

7. Device according to any one of the preceding claims, **characterized in that** the voltage regulator comprises at least one electronic regulation component (12) fixed directly or indirectly to the evaporation part (7) of the heat pipe (6, 60, 61, 63).

8. Device according to Claim 7, **characterized in that** the voltage regulator comprises a layer of plastic material (11) provided with a cavity (34) for housing the electronic component (12).
